(19) Europäisches Patentamt / European Patent Office / Office européen des brevets

(11) **EP 2 051 378 A1**

(12) **EUROPEAN PATENT APPLICATION**

(43) Date of publication:
**22.04.2009 Bulletin 2009/17**

(51) Int Cl.:
*H03H 11/48* (2006.01)

(21) Application number: **07291275.1**

(22) Date of filing: **18.10.2007**

| | |
|---|---|
| (84) Designated Contracting States:<br>**AT BE BG CH CY CZ DE DK EE ES FI FR GB GR HU IE IS IT LI LT LU LV MC MT NL PL PT RO SE SI SK TR**<br>Designated Extension States:<br>**AL BA HR MK RS**<br><br>(71) Applicant: **Alcatel Lucent**<br>**75008 Paris (FR)** | (72) Inventor: **Op de Beeck, Edmond Celina Jozef**<br>**2800 Mechelen (BE)**<br><br>(74) Representative: **Narmon, Gisèle Marie Thérèse et al**<br>**Alcatel Bell N.V.**<br>**Intellectual Property Department**<br>**Copernicuslaan 50**<br>**2018 Antwerpen (BE)** |

(54) **Inductance enchancement circuit**

(57)   An enhancement circuit for enhancing the value of the inductance of a coil having a first winding (L1). The enhancement circuit comprises a second winding (L2) forming a transformer (T) with the first winding and having a first terminal (3) coupled to the ground (Vgrd) and a second terminal (4) coupled to an input of a feedback circuit. The feedback circuit senses the voltage (VL) over the coil and comprises a transconductance amplifier (gm) that amplifies and converts the sensed voltage into a current (I2) injected back in the second winding. In a preferred embodiment, the coil has a pair of windings (L1a, L1b) and is used in a double-ended low-pass filter, as an xDSL splitter for telecommunication applications. The pair of windings (L1a,L1b) is electrically coupled between telecommunication input terminals (Line+,Line-) and output terminals (POTS+, POTS-) of the low-pass filter. The improved enhancement circuit comprises a third (L2) and a fourth (L3) winding both magnetically coupled to the first (L1a) and second (L1b) windings. The third winding (L2) has a first terminal (3) coupled to the ground and a second terminal (4) coupled to the input of the feedback circuit, whilst the fourth winding (L3) has a first terminal (5) also coupled to the ground and a second terminal (6) coupled to the output of the feedback circuit. This feedback circuit senses the voltage (VL) over the coil and comprises a transconductance amplifier (gm) that amplifies and converts the sensed voltage into a current (I3) injected in the fourth winding (L3) via the second terminal (6) thereof.

Fig. 4

**Description**

The present invention relates to an enhancement circuit for enhancing the value of a coil of which the winding is coupled between an input terminal and an output terminal.

Today, coil based filters, as for instance xDSL splitter circuits of telecommunication systems, generally require multiple coils in multiple filter stages to realize the complex filter function that is required. In more detail, today's xDSL splitter circuits use up to 3 bulky coils per DSL line, limiting the integration of the number of splitter circuits per board. As a result, the density of standard compliant splitters has not been able to follow the increasing integration of the xDSL line circuits, resulting in a different numbers of lines per boards between splitters and line circuits.

Known solutions to that problem consist in using a passive filter or an active splitter based on coil enhancement applying the current sensing and current driving principle.

In case of a passive filter, a 3rd order passive splitter has a higher density than a 5th order because it uses only 2 instead of 3 coils. However, this is not standard compliant for attenuation of DSL signals.

The active splitter based on coil enhancement applying the current sensing and current driving principle is known from the European Patent Application No 06291502.0 Entitled "Multiple Order Low Pass Filter for An xDSL Splitter in a Telecommunication System" by E. Op De Beeck (22.09.2006). However, this implementation has practical drawbacks, e.g. for density and cost, due to requirements for common mode rejection, longitudinal conversion loss and protection against over-voltages and over-currents.

An object of the present invention is to provide an enhancement circuit for a coil of the above type but which doesn't have the mentioned drawbacks while consuming a minimum of place on the board.

According to the invention, this object is achieved due to the fact that said enhancement circuit comprises a second winding coupled to the first mentioned winding so as to form a transformer, that said second winding has a first terminal coupled to a ground terminal and a second terminal coupled to an input of a feedback circuit, and that said feedback circuit is adapted to sense the voltage over said coil and comprises a transconductance amplifier adapted to amplify and to convert the sensed voltage to a current injected in said second winding via said second terminal.

In this way it becomes possible to increase and even reduce the value of the coil, and make the coil frequency dependent. This allows to make higher order filters based on a coil and capacitor, with less and smaller coils. The present solution is even less dense than the above mentioned solution of a 3rd order passive splitter while providing better performances.

In a preferred characterizing embodiment of the present invention, said enhancement circuit comprises a second winding and a third winding both coupled to the first mentioned winding so as to form a transformer, said second winding has a first terminal coupled to a ground terminal and a second terminal coupled to an input of a feedback circuit, said third winding has a first terminal coupled to said ground terminal and a second terminal coupled to an output of said feedback circuit, and said feedback circuit is adapted to sense the voltage over said coil and comprises a transconductance amplifier adapted to amplify and to convert the sensed voltage to a current injected in said third winding via the second terminal thereof.

The use of different winding for voltage sensing and current driving, as will be explained below, allows eliminating the parasitic effects of the transformer.

In another preferred characterizing embodiment of the invention, the present enhancement circuit enhances the value of a coil having a pair of windings and used in a double-ended low-pass filter, the first winding of said pair is coupled between a first input terminal and a first output terminal of said low-pass filter, and the second winding of said pair is coupled between a second input terminal and a second output terminal of said low-pass filter. A capacitor is coupled between the first output terminal and the second output terminal of said low-pass filter, and said first winding and said second winding are coupled together so as to form a transformer. This enhancement circuit comprises a third winding and a fourth winding both coupled to said first and said second windings and belonging also to said transformer, said third winding has a first terminal coupled to a ground terminal and a second terminal coupled to an input of a feedback circuit, said fourth winding has a first terminal coupled to said ground terminal and a second terminal coupled to an output of said feedback circuit, and said feedback circuit is adapted to sense the voltage over said coil and comprises a transconductance amplifier adapted to amplify and to convert the sensed voltage to a current injected in said fourth winding via the second terminal thereof.

By applying the enhanced coils of the present invention in the low pass filter of an xDSL POTS splitter of a telecommunication system, a multiple order splitter low pass filter is realized.

Further characterizing embodiments of the present coil enhancement circuit are mentioned in the appended claims.

It is to be noticed that the term 'comprising', used in the claims, should not be interpreted as being restricted to the means listed thereafter. Thus, the scope of the expression 'a device comprising means A and B' should not be limited to devices consisting only of components A and B. It means that with respect to the present invention, the only relevant components of the device are A and B.

Similarly, it is to be noticed that the term 'coupled', also used in the claims, should not be interpreted as being restricted to direct connections only. Thus, the scope of the expression 'a device A coupled to a device B' should not be limited to devices or systems wherein an output of device A is directly connected to an input of device B. It means that there exists a path between an output of A and an input of B which may be a path including other devices or means.

The above and other objects and features of the invention will become more apparent and the invention itself will be best understood by referring to the following description of an embodiment taken in conjunction with the accompanying drawings wherein:

Fig. 1 represents a coil with an enhancement circuit according to the invention;
Fig. 2 represents the enhanced coil of Fig. 1 applied in a low pass filter;
Fig. 3 represents the enhanced coil of Fig. 1 applied in a preferred embodiment;
Fig. 4 represents the enhanced coil of Fig. 3 applied in the low pass filter of an xDSL POTS splitter; and
Fig. 5 represents a preferred variant of the low pass filter shown in Fig. 4.

An enhancement circuit for enhancing the value of a coil is shown at the different Fig's. The principle for enhancing the value of a coil is achieved by:

- sensing the voltage over the coil, on a secondary winding coupled to the coil as a transformer T;
- amplifying and converting this sensed voltage to a current in a transconductance amplifier gm; and
- sending this current again in the secondary winding of the coil.

This principle allows increasing and even reducing the value of the coil, and making the coil frequency dependent. It further allows making higher order filters based on a coil and capacitor, with less and smaller coils.

Different embodiments of the enhancement circuit and applications thereof are shown in the Fig's.

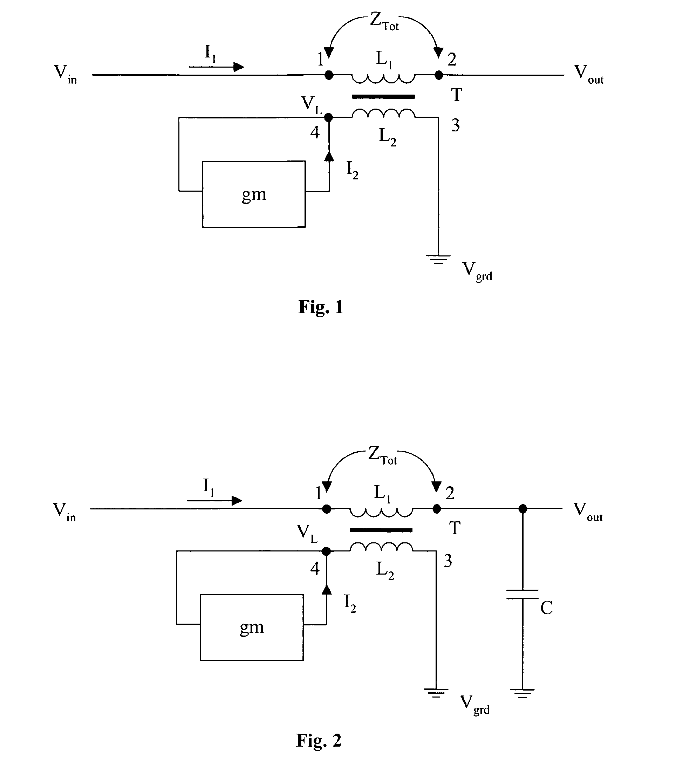

A first enhancement of the value of a coil, having a winding $L_1$ and shown at Fig. 1, is obtained by sensing the voltage over the coil at a secondary winding $L_2$ thereof, filtering and amplifying this sensed voltage, converting it into a current $I_2$, and feeding it back to the secondary winding $L_2$ of the coil.

This enhanced coil circuit is then applied in a low pass filter, shown at Fig. 2, in order to realize a higher order low pass filter based on a single coil (transformer) and a capacitor C.

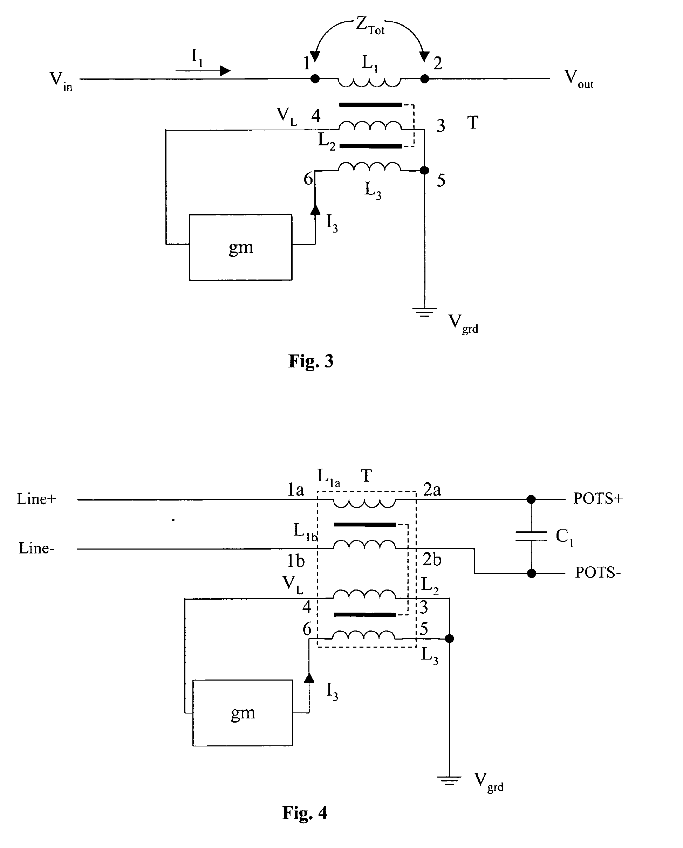

Fig. 3 shows the use of different windings for voltage sensing and for current driving in order to eliminate the parasitic effects of the transformer T.

Fig. 4 shows the application of this filter in the low pass filter of an xDSL POTS splitter, to realize multiple order splitter low pass filter.

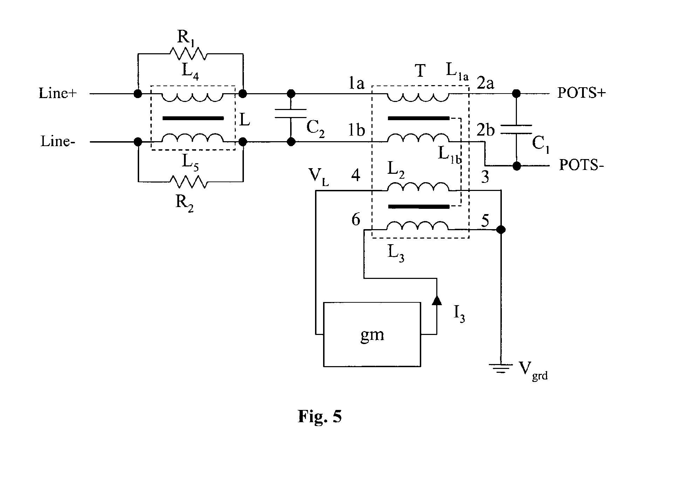

An improved version of this xDSL POTS splitter is shown at Fig. 5.

The basic principle of the enhancement circuit is shown in Fig. 1. In this circuit, the coil has a first winding $L_1$ with a first terminal 1 coupled to an input terminal Vin and with a second terminal 2 coupled to an output terminal Vout. This coil has a second winding $L_2$ coupled to the first winding $L_1$ so as to form a transformer T. This second winding $L_2$ has a first terminal 3 connected to a ground terminal Vgrd and a second terminal 4 coupled to an input of a feedback circuit. The feedback circuit comprises a transconductance amplifier gm which, together with the second winding $L_2$, forms the enhancing circuit for the coil.

The feedback circuit is adapted to sense the voltage $V_L$ over the coil via an input of its transconductance amplifier gm connected to the second terminal 4 of the second winding $L_2$. The transconductance amplifier gm amplifies this sensed voltage and converts it into a current $I_2$ injected back in the second winding $L_2$ via its second terminal 4.

For the ease of the explanation of this coil enhancement circuit, it is assumed that:

$L_1 = L_2$ ; this means n=1

where n is the winding ratio of transformer T

Without feedback circuit, the total impedance $Z_{tot}$ provided by the winding $L_1$ is given by the formula:

$$Z_{tot} = s * L_1$$

The current $I_2$ is generated by sensing the voltage $V_L$ at the secondary of the transformer T, and by amplifying this voltage and converting it to a current in the transconductance amplifier gm:

$$I_2 = gm * V_L$$

The total impedance $Z_{tot}$ between input terminal Vin and output terminal $V_{out}$, with the feedback loop present via the secondary of the transformer T, is given by following formula:

$$Z_{tot} = (s * L_1) / (1 - gm * s * L_1)$$
$$= Z_{L1} / (1 - gm * Z_{L1})$$

where $Z_{L1} = s * L_1$

This means that impedance $Z_{tot}$ is equivalent to impedance $Z_{L1}$ in parallel with the negative impedance -1/gm.

The resulting coil value $L_{tot}$ can be described as:

$$L_{tot} = L_1 / (1 - gm * s * L_1)$$

Based on the sign and the amplitude of gm, the resulting coil value $L_{tot}$ can be higher (enhanced coil) or lower (reduced coil) than the original coil $L_1$:

$$0 < gm * s * L_1 < 1 \qquad = \text{enhanced coil}$$

$$gm * s * L_1 < 0 \qquad = \text{reduced coil}$$

The open loop gain $G_{OL}$ of the feedback loop is given by following equation:

$$G_{OL} = gm * (Z_{L1} // Z_{ext})$$

where $Z_{L1} // Z_{ext}$ is the impedance of $L_1$, parallel with the external impedance $Z_{ext}$, seen across $L_1$

The standard stability criteria apply to the open loop gain.

In the way described above, the value of a coil can be adapted, by adapting the gain of a feedback circuit applied to this coil. This allows enhancing or reducing the value of the coil, and even making the value of the coil frequency dependent, by making the feedback circuit frequency dependent. The explained principle also shows good performance for common mode rejection, longitudinal conversion loss and protection against over-voltages and over-currents, as the feedback circuit is isolated via transformer T from the primary winding ($L_1$) of the coil.

The above enhanced coil principle may be applied in a low pass filter to realize a higher order low pass filter based on a single coil (transformer) and capacitor, as shown at Fig. 2. To this end, in addition to the above described coil enhancement circuit, a capacitor C is coupled between the output terminal Vout and the ground terminal Vgrd.

The filter characteristic without $L_2$ and without feedback is given by:

$$\text{Vout/Vin} = 1 / (1 + s^2 * L_1 * C)$$

The filter characteristic with $L_2$ and with the feedback circuit is given by:

$$\text{Vout/Vin} = 1 / (1 + s^2 * L_{tot} * C) = 1 / (1 + s^2 * (L_1 / (1 - gm * s * L_1)) * C)$$

By making the sign (phase) and amplitude of gm frequency dependent, the value of the coil $L_{tot}$, and the impedance $Z_{tot}$, can be changed over the frequency, allowing higher order filters or complex filter functions, with a single coil.

An improvement of the above coil enhancement circuit is shown at Fig. 3 where different windings $L_2$ and $L_3$ are used for voltage sensing ($L_2$) and current driving ($L_3$). These different windings allow eliminating the parasitic effects of the transformer T.

In more detail, the enhancement circuit shown at Fig. 3 comprises, as in Fig. 1, a coil with a first winding $L_1$ having a first terminal 1 coupled to the input terminal $V_{in}$ and a second terminal 2 coupled to the output terminal $V_{out}$. The circuit of Fig. 3 further comprises a second winding $L_2$ and a third winding $L_3$ both coupled to the winding $L_1$ of the coil so as to form a transformer T. The second winding L2 has a first terminal 3 coupled to the ground terminal $V_{grd}$ and a second terminal 4 coupled to the input of the feedback circuit. The third winding $L_3$ has a first terminal 5 coupled to the ground terminal $V_{grd}$ and a second terminal 6 coupled to the output of the feedback circuit.

As above, the feedback circuit is adapted to sense the voltage $V_L$ over the coil and comprises a transconductance amplifier gm adapted to amplify and to convert the sensed voltage into a current $I_3$ injected in the third winding $L_3$ via its second terminal 6.

It is to be noted that, with respect to the enhancement circuit shown at Fig. 1, the voltage $V_L$ sensed over the secondary winding $L_2$ needs to give an exact representation of the coil. In practice however, there is a resistance in series with the coil (winding resistance $R_s$ of $L_1$, not shown), that creates an additional voltage $I_2 * R_S$ that also contributes to $V_L$. This gives an error on the generated current $I_2$ at the output of the transconductance amplifier gm.

The resulting impedance, for the implementation in Fig. 1, is given by following formula:

$$Z_{tot} = (s * L_1) / (1 - (gm * s * L_1) / (1 - gm * R_s))$$

Since $R_s$ is not exactly known (parasitic of the transformer T), it is relatively difficult to compensate this. Over-compensation of $R_s$ would lead to instability; undercompensation will reduce the resulting impedance $Z_{tot}$.

By adding an additional winding $L_3$ to the transformer T, i.e. separating the winding $L_2$ for voltage sense and the winding $L_3$ for current drive, together with a high input impedance of the voltage sense input of the gm amplifier, this problem is eliminated. The resulting schematic is given at Fig. 3.

When $L_1 = L_2 = L_3$, the same formulae as in embodiment of Fig. 1 (with $R_s=0$) apply.

When the winding ratios between $L_1$, $L_2$ and $L_3$ are not equal to 1, the formula for $Z_{tot}$ is given below:

$$Z_{tot} = (s * L_1) / (1 - gm * s * L_1 / (n_{12} * n_{23}))$$

Where: $n_{12}$ = winding ratio $L_1$ versus $L_2$ = $\sqrt{(L_1/L_2)}$
$n_{13}$ = winding ratio $L_1$ versus $L_3$ = $\sqrt{(L_2/L_3)}$

The improvement of the coil enhancement circuit, by adding an additional winding as shown in Fig. 3, shows how to deal with the parasitic effects of the transformer in a fairly simple way.

The above enhanced coil principle may also be applied in the low pass filter of an xDSL POTS splitter used in telecommunication systems. The enhanced coil circuit then allows realizing a multiple order splitter low pass filter.

Fig. 4 shows a single stage implementation comprising one active stage with an enhanced coil, while Fig. 5 shows a two-stage implementation comprising one passive and one active stage with enhanced coil.

In more detail, the enhancement circuit shown at Fig. 4 enhances the value of a coil having a pair of windings $L_{1a}$, $L_{1b}$ and used in a double-ended low-pass filter. The first winding $L_{1a}$ of this pair is coupled between a first telecommunication input terminal Line+ and a first output terminal POTS+ of the low-pass filter, whilst the second winding $L_{1b}$ of the pair is coupled between a second telecommunication input terminal Line- and a second output terminal POTS-of this low-pass filter.

The first winding $L_{1a}$ and the second winding $L_{1b}$ are coupled together so as to form a transformer T, and more particularly the primary thereof. Because in xDSL balanced signals are used, the two windings $L_{1a}$ and $L_{1b}$ of the primary of the transformer T are balanced windings.

A capacitor $C_1$ is coupled between the first output terminal and the second output terminal of the low-pass filter.

The enhancement circuit further comprises a third winding $L_2$ and a fourth winding $L_3$ both coupled to the first $L_{1a}$ and the second $L_{1b}$ windings and belonging also to the transformer T. The third winding $L_2$ has a first terminal 3 coupled to the ground terminal $V_{grd}$ and has a second terminal 4 coupled to the input of the feedback circuit, whilst the fourth winding $L_3$ has a first terminal 5 coupled to the ground terminal $V_{grd}$ and has a second terminal 6 coupled to the output of the feedback circuit.

As mentioned above, the feedback circuit is adapted to sense the voltage $V_L$ over the coil and comprises a

transconductance amplifier gm adapted to amplify and to convert the sensed voltage to a current $I_3$ injected in the fourth winding $L_3$ its second terminal 6.

Depending on the application and requirements, the implementation can use a single stage approach as shown at Fig. 4 or a dual stage approach as shown at Fig. 5. Also depending on the application (e.g. POTS versus ISDN) the principle used can be enhanced (increased) coil or reduced (suppressed coil) or a combination of both.

In the dual stage approach shown at Fig. 5, the low-pass filter further comprises an additional second coil having a second pair of windings $L_4$, $L_5$ coupled between the telecommunication input terminals Line+ and Line- and the windings $L_{1a}$ and $L_{1b}$ of the first coil used in the double-ended low-pass filter shown at Fig. 4. The windings $L_4$ and $L_5$ of the second coil are coupled together so as to form a second transformer L.

In more detail, the first winding $L_4$ of the second coil is coupled between the first telecommunication input terminal Line+ and a first input 1a of the first winding $L_{1a}$ of the first coil, whilst the second winding $L_5$ of the second coil is coupled between the second telecommunication input terminal Line- and a first input 1b of the second winding $L_{1b}$ of the first coil.

A first resistor $R_1$ is further connected in parallel across the first winding $L_4$ of the second coil, whilst a second resistor $R_2$ is connected in parallel across the second winding $L_5$ of this second coil. Finally, a second capacitor $C_2$ is coupled between the first input 1a of the first winding $L_{1a}$ of the first coil and the first input 1b of the second winding $L_{1b}$ of this first coil.

In some application, also other impedances (e.g. resistors, capacitors) may be coupled in parallel to the primary winding of the transformers.

As shown in Fig.4 and Fig. 5, the enhancement circuit for a coil allows implementing complex filter functions, like xDSL splitters, with less components, with smaller size and at lower cost, by reducing the size and the number of coils required for this filter function.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is merely made by way of example and not as a limitation on the scope of the invention, as defined in the appended claims.

**Claims**

1. An enhancement circuit for enhancing the value of a coil of which the winding (L1) is coupled between an input terminal (Vin) and an output terminal (Vout), *characterized in that* said enhancement circuit comprises a second winding (L2) coupled to the first mentioned winding (L1) so as to form a transformer (T), *in that* said second winding has a first terminal (3) coupled to a ground terminal (Vgrd) and a second terminal (4) coupled to an input of a feedback circuit, *and in that* said feedback circuit is adapted to sense the voltage (VL) over said coil and comprises a transconductance amplifier (gm) adapted to amplify and to convert the sensed voltage to a current (I2) injected in said second winding via said second terminal.

2. The enhancement circuit according to claim 1, *characterized in that* a capacitor (C) is coupled between said output terminal (Vout) and said ground terminal (Vgrd).

3. An enhancement circuit for enhancing the value of a coil of which the winding (L1) is coupled between an input terminal (Vin) and an output terminal (Vout), *characterized in that* said enhancement circuit comprises a second winding (L2) and a third winding (L3) both coupled to the first mentioned winding (L1) so as to form a transformer (T), *in that* said second winding has a first terminal (3) coupled to a ground terminal (Vgrd) and a second terminal (4) coupled to an input of a feedback circuit, *in that* said third winding has a first terminal (5) coupled to said ground terminal and a second terminal (6) coupled to an output of said feedback circuit, *and in that* said feedback circuit is adapted to sense the voltage (VL) over said coil and comprises a transconductance amplifier (gm) adapted to amplify and to convert the sensed voltage to a current (I3) injected in said third winding via the second terminal thereof.

4. An enhancement circuit for enhancing the value of a coil having a pair of windings (L1a, L1b) and used in a double-ended low-pass filter,

the first winding (L1a) of said pair is coupled between a first input terminal (Line+) and a first output terminal (POTS+) of said low-pass filter,

the second winding (L1b) of said pair is coupled between a second input terminal (Line-) and a second output terminal (POTS-) of said low-pass filter,

a capacitor (C1) is coupled between the first output terminal and the second output terminal of said low-pass filter, and said first winding (L1a) and said second winding (L1b) are coupled together so as to form a transformer (T),

***characterized in that*** said enhancement circuit comprises a third winding (L2) and a fourth winding (L3) both coupled to said first (L1a) and said second (L1b) windings and belonging also to said transformer (T),

***in that*** said third winding (L2) has a first terminal (3) coupled to a ground terminal (Vgrd) and a second terminal (4) coupled to an input of a feedback circuit,

***in that*** said fourth winding (L3) has a first terminal (5) coupled to said ground terminal and a second terminal (6) coupled to an output of said feedback circuit,

***and in that*** said feedback circuit is adapted to sense the voltage (VL) over said coil and comprises a transconductance amplifier (gm) adapted to amplify and to convert the sensed voltage to a current (I3) injected in said fourth winding (L3) via the second terminal (6) thereof.

5. The enhancement circuit according to claim 4, ***characterized in that*** the first winding (L1a) and the second winding (L1b) of said transformer (T) are balanced.

6. The enhancement circuit according to claim 4,
***characterized in that*** said low-pass filter further comprises a second coil having a second pair of windings (L4, L5) coupled between said first (Line+) and second (Line-) input terminals and said first (L1a) and second (L1b) windings of the first mentioned coil used in said double-ended low-pass filter,

the first winding (L4) of said second coil being coupled between said first input terminal (Line+) and a first input (1a) of the first winding (L1a) of said first coil,

the second winding (L5) of said second coil being coupled between said second input terminal (Line-) and a first input (1b) of the second winding (L1b) of said first coil,

***in that*** a first resistor (R1) is connected in parallel across the first winding (L4) of said second coil and a second resistor (R2) is connected in parallel across the second winding (L5) of said second coil,

***in that*** a second capacitor (C2) is coupled between the first input (1a) of the first winding (L1a) of said first coil and the first input (1b) of the second winding (L1b) of said first coil,

***and in that*** the first winding (L4) and the second winding (L5) of said second coil are coupled together so as to form a second transformer (L).

Fig. 1

Fig. 2

$Z_{Tot}$

$I_1$

1    $L_1$    2

$V_{in}$    $V_{out}$

$V_L$  4

3    T

$L_2$

6    5

$L_3$

$I_3$

gm

$V_{grd}$

**Fig. 3**

$L_{1a}$    T

Line+    1a    2a    POTS+

$L_{1b}$    $C_1$

Line-    1b    2b    POTS-

$V_L$    $L_2$

4    3

6    5

$L_3$

$I_3$

gm

$V_{grd}$

**Fig. 4**

**Fig. 5**

**European Patent Office**

**EUROPEAN SEARCH REPORT**

Application Number

EP 07 29 1275

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 035 180 A (SIEMENS AG [DE]) 9 September 1981 (1981-09-09) * figure 5 * | 1-6 | INV. H03H11/48 |
| X | US 4 881 262 A (MESCHKAT PETER [DE] ET AL) 14 November 1989 (1989-11-14) * figure 1 * | 1-6 | |
| X | DE 33 23 649 A1 (STANDARD ELEKTRIK LORENZ AG [DE]) 7 February 1985 (1985-02-07) * figures 4,5 * | 3-6 | |
| X | FR 1 467 337 A (SIEMENS AG) 27 January 1967 (1967-01-27) * figures 2b,3a * | 3-6 | |

TECHNICAL FIELDS SEARCHED (IPC)

H03H

The present search report has been drawn up for all claims

| Place of search | Date of completion of the search | Examiner |
|---|---|---|
| The Hague | 22 February 2008 | RADOMIRESCU, B |

EPO FORM 1503 03.82 (P04C01)

**ANNEX TO THE EUROPEAN SEARCH REPORT
ON EUROPEAN PATENT APPLICATION NO.**

EP 07 29 1275

This annex lists the patent family members relating to the patent documents cited in the above-mentioned European search report.
The members are as contained in the European Patent Office EDP file on
The European Patent Office is in no way liable for these particulars which are merely given for the purpose of information.

22-02-2008

| Patent document cited in search report | | Publication date | Patent family member(s) | | Publication date |
|---|---|---|---|---|---|
| EP 0035180 | A | 09-09-1981 | DE | 3007791 A1 | 10-09-1981 |
| | | | JP | 56134721 A | 21-10-1981 |
| US 4881262 | A | 14-11-1989 | AU | 594530 B2 | 08-03-1990 |
| | | | AU | 8116287 A | 26-05-1988 |
| | | | DE | 3640127 A1 | 01-06-1988 |
| | | | EP | 0269055 A2 | 01-06-1988 |
| | | | ES | 2040236 T3 | 16-10-1993 |
| | | | FI | 875141 A | 26-05-1988 |
| | | | NO | 874760 A | 26-05-1988 |
| DE 3323649 | A1 | 07-02-1985 | NONE | | |
| FR 1467337 | A | 27-01-1967 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 06291502 A

**Non-patent literature cited in the description**

- **E. OP DE BEECK.** *Multiple Order Low Pass Filter for An xDSL Splitter in a Telecommunication System,* 22 September 2006